Europäisches Patentamt

**European Patent Office**

**Office européen des brevets**

(11) Publication number : **0 472 347 A2**

# EUROPEAN PATENT APPLICATION

(21) Application number : **91307470.4**

(51) Int. Cl.⁵ : **H01L 21/285, H01L 21/314**

(22) Date of filing : **13.08.91**

(30) Priority : **23.08.90 US 572190**

(43) Date of publication of application :
**26.02.92 Bulletin 92/09**

(84) Designated Contracting States :
**DE FR GB**

(71) Applicant : **AMERICAN TELEPHONE AND TELEGRAPH COMPANY**
**550 Madison Avenue**
**New York, NY 10022 (US)**

(72) Inventor : **Asom, Moses Terlumum**
**48 Brandywine Circle, Box 733**
**Trexlertown, Pennsylvania 18107 (US)**

(74) Representative : **Johnston, Kenneth Graham et al**
**AT&T (UK) LTD. AT&T Intellectual Property Division 5 Mornington Road**
**Woodford Green Essex, IG8 OTU (GB)**

(54) **Method of making a contact on a group III-V compound semiconductor device.**

(57) Formation of an electrical contact to an AlGaAs layer is facilitated by suppressing oxide formation with a Group V layer obtained by decomposition of a Group V hydride.

EP 0 472 347 A2

## Technical Field

This invention relates to a method of making compound semiconductor devices which uses gas phase epitaxy to deposit a passivating layer of a Group V element. Further processing, e.g., formation of electrical contacts on a Group III-V semiconductor, is facilitated because the passivating layer protects the underlying semiconductor material against unwanted degradation.

## Background of the Invention

Optical devices, e.g., light sources, photodetectors, waveguides, are currently of interest for many applications, including communications, optical computing, etc. Many types of materials, such as Group III-V compound semiconductors, are used in such devices. Due to the technological demands placed on the devices, e.g., lifetime, photosensitivity, etc., the semiconductors used in the devices should be of high quality; i.e., they should have relatively few crystalline defects. Many growth techniques have been investigated in attempts to grow such materials. Gas phase epitaxial growth techniques, such as chemical vapor deposition and molecular beam epitaxy, have been extensively developed and art now generally believed capable of producing the highest quality Group III-V compound semiconductors, such as AlGaAs, GaAs, and InP.

Production of high quality semiconductor materials does not insure good devices. Subsequent processing steps, such as ion implantation and annealing as well as metal deposition for electrical contacts, must also be successfully realized to obtain good devices. Depending upon the desired application, the metal deposition may result in ohmic, Schottky barrier, etc., contacts. It is frequently difficult to form good electrical contacts because Group III-V compound semiconductors may have characteristics such as relative fragility, low thermal conductivity, or yet other characteristics such as unwanted surface oxides which make electrical contact formation difficult. The surface oxides compromise the integrity of the semiconductor-metal interface which is necessary for optimum device performance. In addition, some processing steps, such as annealing, require an elevated temperature which may degrade surface quality due to preferential desorption of the most volatile species of the semiconductor.

Gas phase techniques have been devised in attempts to inhibit the formation of unwanted surface oxides after epitaxial growth. One exemplary technique caps the exposed surface of, e.g., AlGaAs or GaAs with a thin layer of arsenic obtained from a solid arsenic source. The gas phase species used to form the layer comes from the solid As source. The presence of arsenic should theoretically prevent the formation of Group III oxides, such as $Al_2O_3$ and $Ga_2O_3$. It has been found experimentally, however, that Group III oxides are still present on the surface because the arsenic is deposited in the form of relatively large grain crystals, e.g., 5 to 25$\mu$m, and the surface coverage is too incomplete to prevent oxidation of Group III elements.

## Summary of the Invention

A method of making a semiconductor device comprising the steps of growing at least one layer of material comprising a Group III-V compound semiconductor on a substrate; depositing a passivating layer of a Group V element on the surface of said at least one layer, said layer of the Group V element coming from decomposing a compound, such as a hydride, to yield a Group V monomer; and further processing said device. The further processing may include deposition of a metal layer or annealing to remove damage caused by ion implantation. In a preferred embodiment, the Group III-V compound semiconductor comprises AlGaAs. In yet another preferred embodiment, the Group V hydride comprises arsine.

## Brief Description of the Drawing

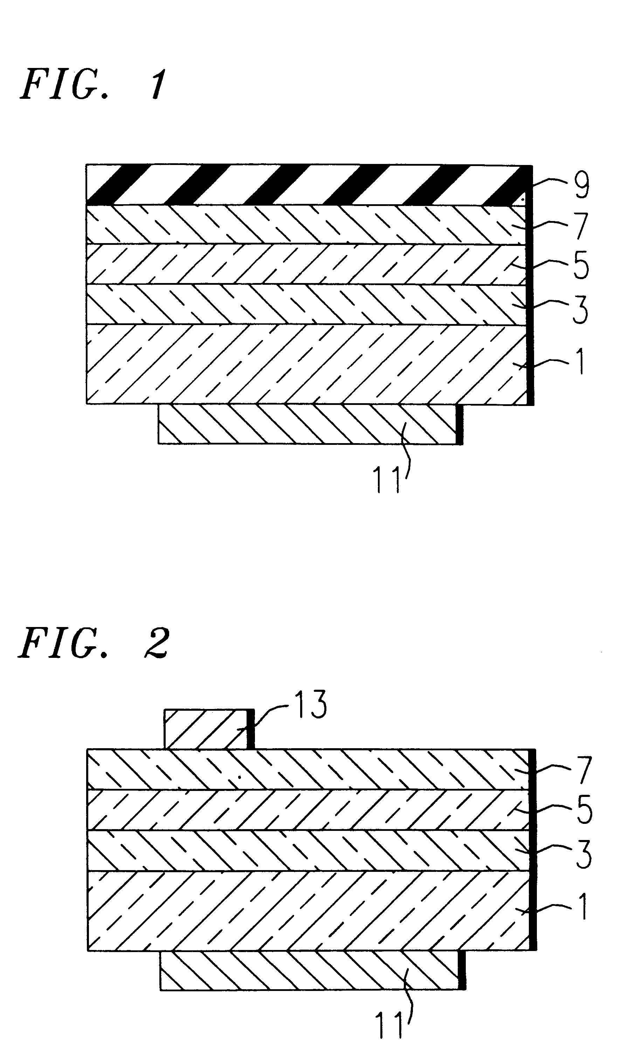

FIGs. 1 and 2 are sectional views useful in explaining the making of a semiconductor device having an electrical contact.

For reasons of clarity, the elements depicted art not drawn to scale.

## Detailed Description

Depicted in FIG. 1 are substrate 1; a plurality of Group III-V compound semiconductor layers 3, 5, and 7; a layer 9 comprising a Group V element; and metal region 11 on the substrate. The substrate comprises a material, such as GaAs or InP, to which the Group III-V semiconductor layers can be grown lattice matched or approximately lattice matched. The group III-V compound semiconductor layers comprise, e.g., AlGaAs. It is to be understood that the diferent layers will have different compositions obtained by varying the ratio of the two Group III elements. It it also to be understood that either of the Group III elements may be absent; that is, the term *AlgaAs* includes AlAs and GaAs. Appropriate metals for contacts will be readily selected by those skilled in the art and further description is not required.

The structure depicted, except for layer 9, is formed by vapor phase epitaxy techniques that are well kown to those skilled in the art. For example, chemical vapor deposition or molecular beam epitaxy may be used to grow the layers. The use of such techniques is sufficiently well known at the present time so that further description is not required.

Layer 9 is formed by the decomposition of a compound, such as a Group V hydride, which yields a Group V monomer which is deposited on surface of the exposed Group III-V layer. For example, arsine may be decomposed to form arsenic monomers. Such decomposition techniques are well known to those skilled in the art and need not be further described. The substrate is desirably cooled at least to ambient temperature and, preferably, below, during this deposition step. The cooled substrate reduces surface mobility, thereby reducing agglomeration, as well as desorption.

The compound used should yield a Group V monomer upon decomposition. Group V elements tend to form molecules, such as dimers, when vaporized from the solid phase. However, when the compound is decomposed in the gas phase, the probability of monomers combining to form dimers can be made relatively low in a suitable cracker. Those skilled in the art will readily select such a cracker. Additionally, the probability of gas phase recombination is low. Accordingly, monomers should be the dominant species deposited on the substrate.

Further processing of the device is now performed. For example, the passivating layer 9 may be desorbing by heating in an ultra high vacuum to expose the underlying semiconductor layer. Metal may now be deposited and patterned to form contacts 13. The resulting structure is depicted in FIG. 2. Additionally, ion implantation may be performed through the passivating layer. The annealing step reduces the damage cause by ion implantation and the passivating layer prevents desorption of the Group V element from the semiconductor layer. The passivating layer should be thick enough so that is not completely desorbed.

It will be readily appreciated some optical measurements may be performed on the structure MBE growth because the top compound semiconductor layer is protected by the arsenic layer. The layers were found to be highly reflective of light. The RHEED (reflected high energy electron diffraction) pattern indicated that the layers are fine-grain polycrystalline.

The structure depicted is for purposes of illustration only and is intended to be representative of numerous types including, but not limited to, lasers, photodetectors, quantum wells, field-effect transistors, etc., that may be fabricated with Group III-V compound semiconductors. Three layers are depicted for purposes of illustration only; more or fewer layers will generally be present.

Variations will be readily thought of by those skilled in the art. For example, the material in the passivatig layer does not have to be in the underlying layer, i.e., As may be used over InP.

## Claims

1. A method of making a semiconductor device comprising the steps of growing at least one layer (e.g. 3, 5, 7) of material comprising a Group III-V compound semiconductor on a substrate (1); depositing a passivating layer (9) of a Group V element and the surface of said at least one layer (3, 5, 7); and further processing said device;
   CHARACTERIZED IN THAT the layer of the Group V element is derived by decomposing a compound to yield a Group V monomer.

2. A method as recited in claim 1 in which said compound comprises a Group V hydride.

3. A method as recited in claim 2 in which said Group V hydride comprises arsine.

4. A method as recited in claim 1 in which said Group V element comprises arsenic.

5. A method as recited in claim 1 in which said Group III-V compound semiconductor comprises A1GaAs.

6. A method as recited in claim 1 in which said further processing comprises heating said passivating layer (9) and depositing a meter (13).

7. A method as recited in claim 1 in which said further processing comprises ion implanting and annealing.

8. A method as recited in claim 1 further comprises cooling said substrate (1).

## FIG. 1

## FIG. 2